# EUROPEAN PATENT SPECIFICATION

(11) **EP 2 797 119 B1**
(45) Date of publication and mention of the grant of the patent: **04.09.2019**
(21) Application number: 14001447.3
(22) Date of filing: 22.04.2014
(51) Int. Cl.: H01L 31/0224, H01L 31/05, H01L 31/068

(54) **Solar cell**
Solarzelle
Cellule solaire

(30) Priority: 22.04.2013 KR 20130044370
(43) Date of publication of application: 29.10.2014
(73) Proprietor: LG Electronics Inc., Seoul 150-721 (KR)
(72) Inventor: Shin, Myungjun, Seoul 137-724 (KR); Kwon, Taeyoung, Seoul 137-724 (KR); Kim, Youngwook, Seoul 137-724 (KR); Kim, Hansang, Seoul 137-724 (KR); Cho, Haejong, Seoul 137-724 (KR)
(74) Representative: Katérle, Axel

(56) References cited:
- WO-A1-2012/102122
- WO-A1-2012/102188
- JP-A- H09 293 889
- JP-A- 2011 228 529
- US-A1- 2012 312 367

## Description

### CROSS-REFERENCE TO RELATED APPLICATION

This application claims the priority benefit of Korean Patent Application No. 10-2013-0044370, filed on April 22, 2013 in the Korean Intellectual Property Office.

### BACKGROUND OF THE INVENTION

### 1. Field of the invention

The present invention relates to a solar cell, and more particularly to a solar cell having an improved configuration.

### 2. Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy using semiconductor devices.

Solar cells may be classified into silicon solar cells, compound solar cells, dye sensitized solar cells, thin film solar cells, and the like. These solar cells may be fabricated via formation of various layers and electrodes based on design. The design of various layers and electrodes may determine the efficiency of a solar cell. In one example, excessively increasing the area of an electrode may increase the amount of materials used and deteriorate the efficiency of a solar cell due to surface recombination. On the other hand, excessively reducing the area of an electrode may cause difficulty in sufficient collection of electric charge. Thus, there is a need to design an electrode having an area, a configuration, and the like to maximize solar cell efficiency.

### SUMMARY OF THE INVENTION

Therefore, the present invention has been made in view of the above problems, and it is an object of the present invention to provide a solar cell, which has excellent characteristics and a low defect rate.

The object is solved by the features of the respective claim 1. Further developments and embodiments are defined in the respective dependent claims.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a simplified sectional view showing a solar cell in accordance with an embodiment of the present invention;
FIG. 2 is a plan view showing a front surface of the solar cell shown in FIG. 1;
FIG. 3 is a rear plan view of an example of the solar cell;
FIG. 4 is a view explaining how connection using connecting projections is accomplished despite occurrence of an alignment error in the solar cell;
FIG. 5 is a plan view showing one alternative example of the connecting projections in the solar cell;
FIG. 6 is a plan view showing another alternative example of the connecting projections in the solar cell;
FIG. 7 is a plan view showing still another alternative example of the connecting projections in the solar cell;
FIG. 8 is a plan view showing a further alternative example of the connecting projections in the solar cell;
FIG. 9 is a partial rear plan view of a solar cell in accordance with another example of the solar cell;
FIG. 10 is a partial rear plan view of a solar cell in accordance with still another example of the solar cell;
FIG. 11 is a partial rear plan view of an embodiment of the solar cell of the present invention; and
FIG. 12 is a sectional view of an example of a solar cell.

### DETAILED DESCRIPTION OF THE PREFERRED EMBODIMENTS

Reference will now be made in detail to the preferred embodiments of the present invention, examples of which are illustrated in the accompanying drawings. However, it will be understood that the present invention should not be limited to the embodiments and may be modified in various ways.

In the drawings, to clearly and briefly explain the present invention, illustration of elements having no connection with the description is omitted, and the same or extremely similar elements are designated by the same reference numerals throughout the specification. In addition, in the drawings, for more clear explanation, the dimensions of elements, such as thickness, width, and the like, are exaggerated or reduced, and thus the thickness, width, and the like of the present invention are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

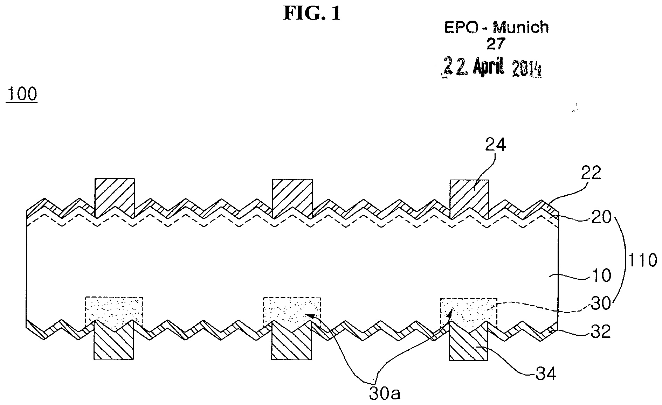

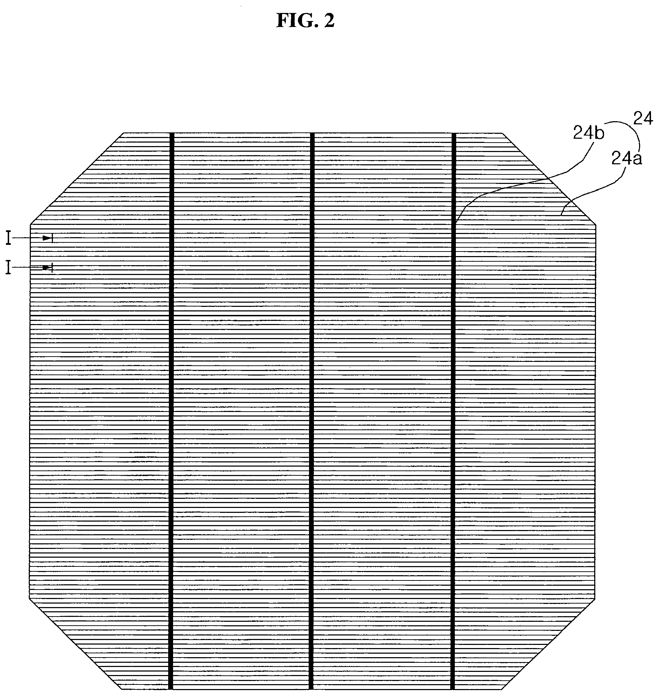

FIG. 1 is a partial sectional view showing a solar cell in accordance with an embodiment of the present invention, and FIG. 2 is a plan view showing a front surface of the solar cell shown in FIG. 1. Particularly, FIG. 1 is a sectional view taken along line I-I of FIG. 2.

Referring to FIG. 1, the solar cell 100, designated by reference numeral 100, in accordance with the present embodiment may include a substrate (e.g., a semiconductor substrate)(hereinafter, referred to as "semiconductor substrate") 110, dopant layers 20 and 30 formed on the semiconductor substrate 110, and electrodes 24 and 34 electrically connected to the dopant layers 20 and 30 respectively. The dopant layers 20 and 30 may include an emitter layer 20 and a back surface field layer 30. The electrodes 24 and 34 may include a first electrode 24 electrically connected to the emitter layer 20, and a second electrode 34 electrically connected to the back surface field layer 30. In addition, the solar cell 100 may further include an anti-reflection film 22 and a passivation film 32, for example. This will be described below in more detail.

The semiconductor substrate 110 consists of an area where the dopant layers 20 and 30 are provided, and a base area 10 where the dopant layers 20 and 30 are not provided. The base area 10, for example, may be formed of silicon containing a first conductive dopant. The silicon may be single-crystal silicon or poly silicon, and the first conductive dopant may be an n-type dopant, for example. That is, the base area 10 may be formed of single-crystal silicon or poly silicon doped with a group-V element, such as phosphorous (P), arsenic (As), bismuth (Bi), antimony (Sb), or the like.

Through the use of the base area 10 containing the n-type dopant described above, the emitter layer 20 containing a p-type dopant is formed on a first surface (hereinafter referred to as "front surface") of the semiconductor substrate 110, thereby forming a p-n junction therebetween. When light is emitted to the p-n junction, electron-hole pairs are generated, and the electrons generated by the photo-electric effect move to a second surface (hereinafter referred to as "back surface") of the semiconductor substrate 110 to thereby be collected by the second electrode 34, and the holes move to the front surface of the semiconductor substrate 110 to thereby be collected by the first electrode 24. This results in generation of electrical energy. In this case, as the holes, which have mobility lower that of the electrons, move to the front surface of the semiconductor substrate 110 rather than the back surface of the semiconductor substrate 110, the conversion efficiency of the solar cell 100 may be enhanced. However, naturally, the present invention is not limited thereto and the base area 10 may contain a p-type dopant.

The front surface and/or the back surface of the semiconductor substrate 110 may be a textured surface provided with protrusionss and recesses of various shapes (such as a pyramidal shape). The textured front and/or back surface of the semiconductor substrate 110, provided with the protrusions and recesses, may attain increased surface roughness, which may reduce reflectance of incident light to the front surface and the back surface of the semiconductor substrate 110. Consequently, the quantity of light reaching the p-n junction at an interface of the semiconductor substrate 110 and the emitter layer 20 may be increased, resulting in minimized light loss of the solar cell 100.

The emitter layer 20 containing a second conductive dopant may be formed on the front surface of the semiconductor substrate 110. In the present embodiment, the second conductive dopant of the emitter layer 20 may be a p-type dopant including a group-III element, such as boron (B), aluminum (Al), gallium (Ga), indium (In), or the like. In this case, according to the present embodiment, the emitter layer 20 may take the form of a homogeneous emitter having a uniform doping density. However, naturally, the present invention is not limited thereto, and the emitter layer 20 may take the form of a selective emitter. This will be described below in detail.

The emitter layer 20 may be formed by doping the semiconductor substrate 110 with the second conductive dopant using various doping methods. In one example, thermal diffusion, ion doping, laser doping, and other doping methods may be used.

The anti-reflection film 22 and the first electrode 24 are formed over the semiconductor substrate 110, more particularly, on the emitter layer 20 formed on the semiconductor substrate 110.

The anti-reflection film 22 may be formed over substantially the entire front surface of the semiconductor substrate 110 except for a portion where the first electrode 24 is formed. The anti-reflection film 22 serves to reduce reflectance of incident light to the front surface of the semiconductor substrate 110 and to passivate defects present in a surface or a bulk of the emitter layer 20.

Through reduction in the reflectance of incident light to the front surface of the semiconductor substrate 110, the quantity of light reaching the p-n junction at the interface of the semiconductor substrate 110 and the emitter layer 20 may be increased. As such, short-circuit current Isc of the solar cell 100 may be increased. In addition, passivation of defects present in the emitter layer 20 may remove a recombination site of a minority carrier, which may increase the open-circuit voltage Voc of the solar cell 100. As such, the anti-reflection film 22 may increase the open-circuit voltage and the short-circuit current of the solar cell 100, thereby enhancing the efficiency of the solar cell 100.

The anti-reflection film 22 may be formed of one or more of various materials. In one example, the anti-reflection film 22 may have a single film structure or a multi-layer film structure formed of at least one material selected from a group consisting of silicon nitride, silicon nitride containing hydrogen, silicon oxide, silicon oxide nitride, aluminum oxide, hafnium oxide, MgF₂, ZnS, TiO₂, and CeO₂. However, naturally, the present invention is not limited thereto, and the anti-reflection film 22 may be formed of one or more of various other materials. In addition, an additional front passivation film (not shown) may be interposed between the semiconductor substrate 110 and the anti-reflection film 22. This falls within the scope of the present invention. The anti-reflection film 22 may be formed using various methods, such as vacuum deposition, chemical vapor deposition, spin coating, screen printing, spray coating, or the like.

The first electrode 24 is electrically connected to the emitter layer 20 through an opening perforated in the anti-reflection film 22 (i.e. the first electrode 24 penetrating the anti-reflection film 22). The first electrode 24 may be formed of one or more of various materials and may have any one shape among various shapes. This will again be described below.

The back surface field layer 30 is formed on the back surface of the semiconductor substrate 110 and contains the first conductive dopant at a higher doping density than that of the semiconductor substrate 110. In the present embodiment, the back surface field layer 30 may contain an n-type dopant including a group-V element, such as phosphorous (P), arsenic (As), bismuth (Bi), antimony (Sb), or the like.

In this case, according to the present embodiment, the back surface field layer 30 includes a plurality of first portions 30a in the form of local portions adjoining to the second electrode 34 (for example, in contact with the second electrode 34). That is, the back surface field layer 30 defines a local back surface field to prevent, for example, damage to the semiconductor substrate 110 during formation of the back surface field layer 30.

The back surface field layer 30 may be formed by doping the semiconductor substrate 110 with the first conductive dopant using various doping methods. In one example, thermal diffusion, ion doping, laser doping, and other doping methods may be used. In the present embodiment, the back surface field layer 30 is formed via implementation of an additional doping process using an n-type dopant (such as a process separate from formation of the second electrode 34). For reference, assuming that the back surface field layer 30 is a p-type, the back surface field layer 30 may be formed as the second electrode 34 is formed of, for example, aluminum, and is subjected to thermal treatment for diffusion of aluminum (i.e. the back surface field layer 30 being formed during formation of the second electrode 34).

In addition, the passivation film 32 and the second electrode 34 may be disposed at the back surface of the semiconductor substrate 110.

The passivation film 32 may be formed over substantially the entire back surface of the semiconductor substrate 110 except for a portion where the second electrode 34 is formed. The passivation film 32 serves to passivate defects present in the back surface of the semiconductor substrate 110, thereby removing a recombination site of a minority carrier. This may increase the open-circuit voltage of the solar cell 100.

The passivation film 32 may be formed of a transparent insulator material to permit transmission of light. Thus, as light may also be introduced into the back surface of the semiconductor substrate 110 through the passivation film 32, the efficiency of the solar cell 100 may be enhanced. That is, the solar cell 100 of the present embodiment is a double-sided light receiving type solar cell to permit introduction of light through both surfaces thereof.

In one example, the passivation film 32 have a single film structure or a multi-layer film structure formed of at least one material selected from a group consisting of silicon nitride, silicon nitride containing hydrogen, silicon oxide, silicon oxide nitride, aluminum oxide, hafnium oxide, MgF₂, ZnS, TiO₂, and CeO₂. However, naturally, the present invention is not limited to the above description, and the passivation film 32 may be formed of one or more of various other materials. The passivation film 32 may be formed using various methods, such as vacuum deposition, chemical vapor deposition, spin coating, screen printing, spray coating, or the like.

The second electrode 34 is electrically connected to the back surface field layer 30 through an opening perforated in the passivation film 32 (i.e. the second electrode 34 penetrating the passivation film 32).

The first electrode 24 described above may be formed by perforating an opening in the anti-reflection film 22 and performing plating, deposition, or the like in the opening. Likewise, the second electrode 34 described above may be formed by perforating an opening in the passivation film 32 and performing plating, deposition, or the like in the opening. Alternatively, the first and second electrodes 24 and 34 may be formed by applying paste for formation of the first and second electrodes respectively to the anti-reflection film 22 and the passivation film 32 via, for example, screen printing, and thereafter performing fire-through, laser firing contact, or the like on the applied paste. In this case, an additional process of perforating the opening is unnecessary. In this context, in a case in which the back surface field layer 30 is formed separately from the second electrode 34 as described above, precise alignment between the back surface field layer 30 and the second electrode 34 is necessary to provide the solar cell 100 with improved characteristics and a lower defect rate.

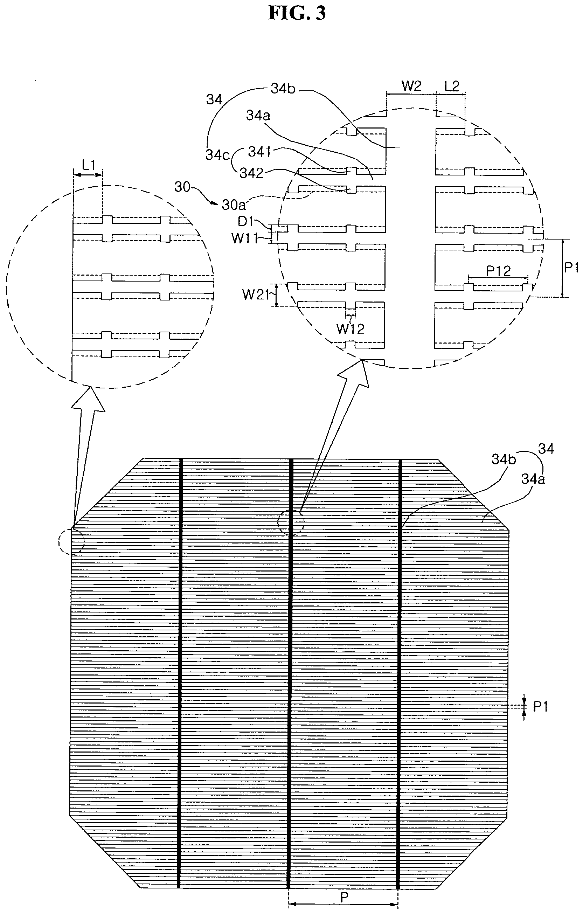

The first electrode 24 according to the present embodiment may have various planar shapes that permit double-sided light reception. First, a configuration of the first electrode 24 will be described in detail with reference to FIG. 2, and then a configuration of the second electrode 34 and the back surface field layer 30 will be described in detail with reference to FIG. 3.

Referring to FIG. 2, the first electrode 24 may include a plurality of finger electrodes 24a arranged in parallel to one another at a constant pitch. In addition, the first electrode 24 may include a bus bar electrode 24b crossing the finger electrodes 24a to connect the finger electrodes 24a to one another. Although only one bus bar electrode 24b may be provided, as exemplarily shown in FIG. 2, a plurality of bus bar electrodes 24b may be arranged at a greater pitch than the pitch of the finger electrodes 24a. In this case, the width of the bus bar electrodes 24b may be greater than the width of the finger electrodes 24a, but the present invention is not limited thereto, and the bus bar electrodes 24b and the finger electrodes 24a may have the same width. The above described shape of the first electrode 24 is merely one example, and the present invention is not limited thereto.

When viewing in cross section, both the finger electrodes 24a and the bus bar electrodes 24b may penetrate the anti-reflection film 22. Alternatively, the finger electrodes 24a may penetrate the anti-reflection film 22, and the bus bar electrodes 24b may be formed on the anti-reflection film 22.

FIG. 3 is a rear plan view of the solar cell in accordance with one example of the solar cell. For clear illustration and explanation, FIG. 3 shows only the back surface field layer 30 and the second electrode 34.

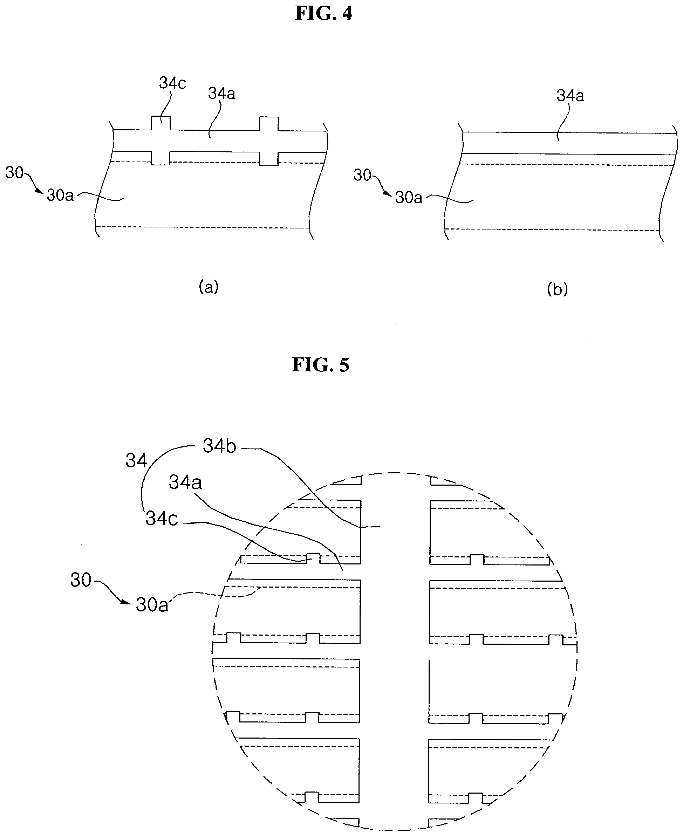

Referring to FIG. 3, the second electrode 34 may include a plurality of finger electrodes 34a arranged in parallel to one another at a first pitch P1. In addition, the second electrode 34 may include a bus bar electrode 34b crossing the finger electrodes 34a to connect the finger electrodes 34a to one another. Although only one bus bar electrode 34b may be provided, as exemplarily shown in FIG. 3, a plurality of bus bar electrodes 34b may be arranged at a greater pitch P than the first pitch P1 of the finger electrodes 34a. In this case, the width W2 of the bus bar electrodes 34b may be greater than the width W11 of the finger electrodes 34a, but the present invention is not limited thereto, and the bus bar electrodes 34b and the finger electrodes 34a may have the same width. In addition, in the present embodiment, each finger electrode 34a of the second electrode 34 is provided with a plurality of connecting projections 34c (for example, first connecting projections 34c). That is, the second electrode 34 includes the bus bar electrodes 34b, the finger electrodes 34a, and the connecting projections 34c protruding from the finger electrodes 34a to extend in a direction perpendicular to the finger electrodes 34a. The connecting projections 34c provided at each of the finger electrodes 34a serve to electrically connect the finger electrode 34a and the corresponding first portion 30a to each other even when the first portion 30a and the finger electrode 34a deviate from each other due to a process error during alignment of the first portion 30a and the finger electrode 34a. This will be described below in more detail with reference to FIG. 4.

FIG. 4 is a view explaining how connection using connecting projections is accomplished despite occurrence of an alignment error in the solar cell. In FIG. 4, (a) is a plan view showing the finger electrode 34a and the first portion 30a under the occurrence of an alignment error in the solar cell in accordance with the embodiment of the present invention, and (b) is a plan view showing the finger electrode 34a and the first portion 30a under the occurrence of an alignment error in a conventional solar cell, the conventional solar cell being not provided with the connecting projections 34c.

Referring to (a) of FIG. 4, through provision of the connecting projections 34c, each finger electrode 34a and each first portion 30a are electrically connected to each other via the connecting projections 34c even if an alignment error equal to the protruding length of the connecting projections 34c (see reference character D1 of FIG. 3) occurs. In this case, the second electrode 34 and the back surface field layer 30 may be operated even under the condition of partial contact over an extremely small area. Thus, sufficient operation of the solar cell 100 may be accomplished even when the finger electrode 34a and the first portion 30a are simply connected to each other via the connecting projections 34c having the minimum size. In this way, connection between the second electrode 34 and the back surface field layer 30 may be accomplished via the connecting projections 34c even under the occurrence of an alignment error. On the other hand, referring to (b) of FIG. 4, in the case of a conventional solar cell, when the finger electrode 34a is located outside the first portion 30a under the occurrence of an alignment error, connection between the finger electrode 34a and the first portion 30a is not accomplished. In the worst case, the solar cell 100 may not be operated due to shunt, etc., when the finger electrode 34a and the first portion 30a completely deviate from each other. This consequently increases a defect rate of the solar cell 100.

Now, the connecting projections 34c will be described in more detail with reference to FIG. 3. The connecting projections 34c described above may be formed simultaneously with formation of the bus bar electrodes 34b and/or the finger electrodes 34a. That is, while the bus bar electrodes 34a and/or the finger electrodes 34a are formed via printing, plating, or the like, the connecting projections 34c may be simultaneously formed via printing, plating, or the like. Accordingly, as a result of forming the connecting projections 34c during formation of the second electrode 34 without an additional process, advantages in terms of productivity may be attained. When viewing in cross section, all of the finger electrodes 34a, the bus bar electrodes 34b, and the connecting projections 34c may penetrate the passivation film 32. Alternatively, the finger electrodes 34a and the connecting projections 34c may penetrate the passivation film 32, and the bus bar electrodes 24b may be formed on the passivation film 32. Naturally, various other alternative embodiments are possible.

As described above, the connecting projections 34c serve to assist connection between the finger electrodes 34a and the back surface field layer 30. In a case in which the connecting projections 34c have a large size, the second electrode 34 has an increased area, thus exhibiting increased recombination and greater shading loss, which may deteriorate characteristics of the solar cell 100. For this reason, it is desirable to provide the connecting projections 34c with the minimum size to achieve connection between the finger electrodes 34a and the back surface field layer 30.

In one example, the width W12 of each connecting projection 34c may be equal to or less than the width W11 of each finger electrode 34a. In one example, a ratio W12/W11 of the width W12 of the connecting projection 34c to the width W11 of the finger electrode 34a may be within a range of 0.3 to 1.0. When the ratio W12/W11 is below 0.3, the width W12 of the connecting projection 34c is too small to achieve efficient connection between the second electrode 34 and the back surface field layer 30. When the ratio W12/W11 exceeds 1.0, the width W12 of the connecting projection 34c may deteriorate characteristics of the solar cell 100. Concrete values of the widths W11 and W12 and the ratio thereof may vary according to the size of the solar cell 100, the kind of the solar cell 100, and the like.

In addition, the ratio W12/W21 of the width W12 of each connecting projection 34C to the width W21 of each first portion 30a, for example, may be within a range of 0.2 to 1.5. The ratio W12/W21 is determined in consideration of alignment characteristics, the areas of the back surface field layer 30 and the second electrode 34, and the like. Accordingly, naturally, the above ratio may have different numerical values.

The protruding length D1 of the connecting projection 34c may be less than the first pitch P1 between the finger electrodes 34a. In this case, the ratio D1/P1 of the protruding length D1 of the connecting projection 34c to the first pitch P1 between the finger electrodes 34a may be 0.6 or less. When the ratio D1/P1 exceeds 0.6, the connecting projections 34c of the neighboring finger electrodes 34a may be connected to each other, and the connecting projections 34c may have an excessively long length, causing deterioration in the characteristics of the solar cell 100. In one example, the ratio D1/P1 of the protruding length D1 of the connecting projection 34c to the first pitch P1 between the finger electrodes 34a may be within a range of 0.05 to 0.3. When the ratio D1/P1 is below 0.05, the protruding length D1 of the connecting projection 34c is too small to sufficiently deal with an alignment error. When the ratio D1/P1 exceeds 0.3, the protruding length D1 of the connecting projection 34c may be unnecessarily increased. Concrete values of the above dimensions D1 and P1 and the ratio thereof may vary according to the size of the solar cell 100, the kind of the solar cell 100, and the like.

A plurality of connecting projections 34c may be formed at each finger electrode 34a at a constant second pitch P12. This may ensure effective connection between the corresponding finger electrode 34a and the back surface field layer 30 under the occurrence of a process error, for example. Explaining this in more detail, a process error may occur due to a vertical or horizontal shift, or may occur due to rotation. In this case, when a horizontal shift occurs by a given distance, the finger electrode 34a and the back surface field layer 30 may be connected to each other even through provision of a single connecting projection 34c. However, when problematic alignment in terms of a rotation direction occurs, providing a plurality of connecting projections 34c may be necessary to achieve more reliable connection between the finger electrode 34a and the back surface field layer 30. That is, in the present example, a plurality of connecting projections 34c may be provided to deal with various kinds of alignment errors.

In this case, the second pitch P12 may be greater than the width W11 of the finger electrode 34a. When the second pitch P12 is less than the width W11 of the finger electrode 34a, the connecting projections 34c are densely arranged to increase the area of the second electrode 34, which may deteriorate characteristics of the solar cell 100.

More specifically, the ratio P12/P1 of the second pitch P12 between the connecting projections 34c to the first pitch P1 between the finger electrodes 34a may be 0.5 or more (for example, within a range of 0.5 to 3.0). In addition, when the ratio is below 0.5, the connecting projections 34c increase the area of the entire second electrode 34, causing deterioration in the characteristics of the solar cell 100. When the ratio exceeds 3.0, effective connection between the second electrode 34 and the back surface field layer 30 cannot be accomplished under the occurrence of various types of alignment errors.

Here, the second pitch P12 may be within a range of 0.5 mm to 2.0 mm. When the second pitch P12 is below 0.5 mm, the characteristics of the solar cell 100 may be deteriorated. When the second pitch P12 exceeds 2.0 mm, effective connection between the second electrode 34 and the back surface field layer 30 may be impossible under the occurrence of various types of alignment errors. However, the aforementioned numerical values may vary according to the size of the solar cell 100, the kind of the solar cell 100, and the like.

Among the plurality of connecting projections 34c, any one connecting projection 34c proximate to the edge of the solar cell 100 (or the edge of the semiconductor substrate 110) may be spaced apart from the edge of the solar cell 100. Since the back surface field layer 30 may not be formed at the edge of the solar cell 100 by reason of, for example, isolation, eliminating the connecting projection 34c at this portion may minimize the number of the connecting projections 34c. In one example, a distance L1 between the corresponding connecting projection 34c and the edge of the solar cell 100 may be within a range of 0.2 mm to 1.0 mm. However, naturally, the present example is not limited thereto and various other alternative embodiments are possible.

In addition, among the plurality of connecting projections 34c, any one connecting projection 34c proximate to each bus bar electrode 34b may be spaced apart from the bus bar electrode 34b. This serves to provide the bus bar electrode 34b with a relatively large width so as to compensate for an alignment error near the bus bar electrode 34b. In this way, as a result of the connecting projection 34c and the bus bar electrode 34b being spaced apart from each other, the number of the connecting projections 34c may be minimized. In one example, the distance L2 between the corresponding connecting projection 34c and the bus bar electrode 34b may be within a range of 0.1 mm to 1.0 mm. However, naturally, the present invention is not limited thereto and various other alternative embodiments are possible.

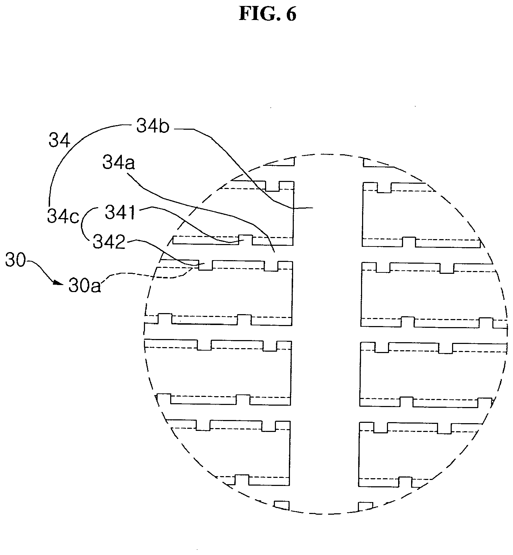

FIG. 3 illustrates that each connecting projection 34c includes a first protruding portion 341 at one side of the finger electrode 34a and a second protruding portion 342 at the other side of the finger electrode 34a, and that the first and second protruding portions 341 and 342 are positioned to correspond to each other. That is, the first and second protruding portions 341 and 342 are symmetrical to each other on the basis of the finger electrode 34a. With this configuration, the connecting projection 34c may deal with a shift caused in a direction perpendicular to the longitudinal direction of the finger electrode 34a. However, the present example is not limited thereto, and various other alternative embodiments are possible. In one example, as exemplarily shown in FIG. 5, the connecting projection 34c may protrude from only one side of the finger electrode 34a. This may effectively prevent increase in the area of the second area 34 by eliminating the connecting projection 34c at the other side of the finger electrode 34a. Alternatively, as exemplarily shown in FIG. 6, the connecting projection 34c may include the first and second protruding portions 341 and 342, and the first and second protruding portions 341 and 342 may be alternately arranged on the basis of the finger electrode 34a. This may prevent concentration of thermal stress due to the first and second protruding portions 341 and 342, resulting in enhanced thermal stability. Naturally, various other alternative embodiments are possible.

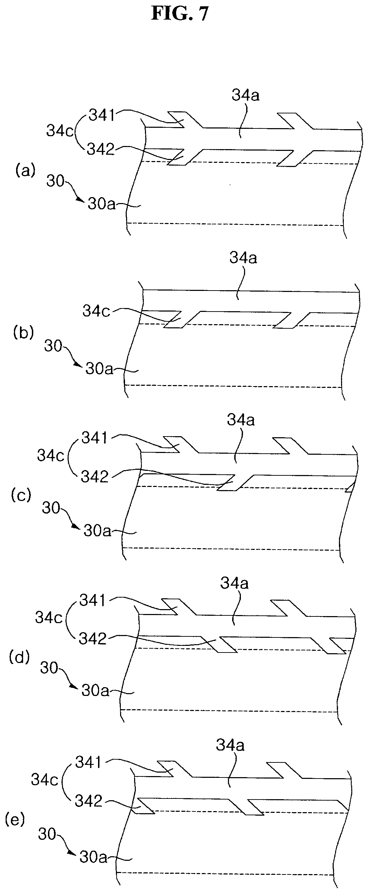

In addition, FIG. 3 illustrates that the connecting projection 34c orthogonally protrudes from the finger electrode 34a and has a rectangular shape, but the present example is not limited thereto. Thus, as exemplarily shown in FIG. 7, the connecting projection 34c may be tilted to the finger electrode 34a.

In this context, as exemplarily shown in (a) of FIG. 7, the connecting projection 34c may include the first and second protruding portions 341 and 342, which are arranged respectively at both sides of the finger electrode 34a at positions corresponding to each other. In this case, the first and second protruding portions 341 and 342 may be symmetrically tilted in opposite directions on the basis of the finger electrode 34a. Alternatively, as exemplarily shown in (b) of FIG. 7, the tilted connecting projection 34c may be formed at only one side of the finger electrode 34a. Alternatively, as exemplarily shown in (c) of FIG. 7, the connecting projection 34c may include the first and second protruding portions 341 and 342 provided respectively at both sides of the finger electrode 34a, and the first and second protruding portions 341 and 342 may be alternately arranged. Alternatively, as exemplarily shown in (d) and (e) of FIG. 7, the first and second protruding portions 341 and 342 of the connecting projection 34c may be tilted in the same direction.

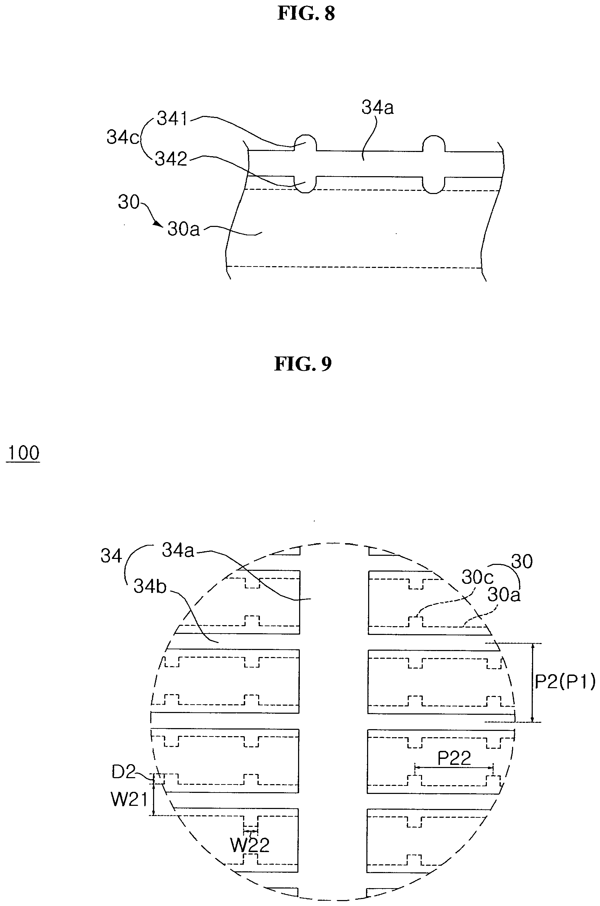

In addition, as exemplarily shown in FIG. 8, the connecting projection 34c may take the form of a rounded projection (for example, a semi-circular or semi-oval projection). In addition, the connecting projection 34c may have various other shapes, such as triangular and pentagonal shapes. Naturally, it will be appreciated that various alternative embodiments of FIG. 7 may also be applied to FIG. 8.

In addition, FIG. 3 illustrates that the connecting projections 34c formed at the respective finger electrodes 34a are arranged side by side at positions corresponding to each other. However, the present example is not limited thereto. The connecting projections 34c formed at the respective finger electrodes 34a may be not positioned side by side.

In the present example, through provision of the connecting projections 34c, effective connection between the second electrode 34 and the back surface field layer 30 and consequently, a lower defect rate of the solar cell 100 may be accomplished. This may considerably enhance the reliability and productivity of the solar cell 100. In this context, according to the present embodiment, dimensions associated with the connecting projections 34c, such as the width W12, the protruding length D1, the second pitch P12, and the distances L1 and L2 from the edge of the solar cell 100 and the bus bar electrode 34b, may be defined to maintain the area of the second electrode 34 at a small value and to ensure more effective connection between the second electrode 34 and the back surface field layer 30. In this way, the solar cell 100 may achieve a high level of characteristics and a considerably reduced defect rate.

In particular, in the present example, the back surface field layer 30 is an n-type and is formed separately from the second electrode 34, thus easily dealing with an alignment error. However, naturally, the present example is not limited thereto, and may be applied even when the base region 10 is a p-type. In addition, as a result of the first electrode 24, which is greatly associated with characteristics of the solar cell 100 due to, for example, shading loss, being not provided with the connecting projections 34c and only the second electrode 34 located at the back surface being provided with the connecting projections 34c, the maximized use of light introduced into the front surface may be accomplished. However, the present example is not limited thereto, and the connecting projections may also be formed at the front surface.

Hereinafter, a solar cell in accordance with other examples of the solar cell and in accordance with the solar cell's embodiment of the present invention will be described in more detail with reference to FIGS. 9 to 10 and 11-12, respectively.

FIG. 9 is a partial rear plan view of a solar cell in accordance with another example of the solar cell.

Referring to FIG. 9, in the present example, connecting projections 30c (for example, second connecting projections 30c) are formed at the first portions 30a of the back surface field layer 30. That is, the back surface field layer 30 may include the first portions 30a and the connecting projections 30c protruding from each of the first portions 30a.

In this case, the connecting projections 30c may be formed using a process of forming the first portion 30a. That is, the first portion 30a and the connecting projections 30c may be doped simultaneously with doping of a first conductive dopant via various doping methods, such as ion implantation, thermal diffusion, or the like. Thereby, the connecting projections 30c may be easily formed by simply changing a mask used in a doping process without an additional process. In addition, providing the back surface field layer 30 with the connecting projections 30c may assist the solar cell 100 in maintaining more excellent characteristics. That is, when the area of the entire finger electrodes 34a deviates from a relatively low specific criterion, sudden recombination of electrons and holes occurs, causing considerable deterioration in the characteristics of the solar cell 100. That is, characteristics of the solar cell 100 may vary sensitive to increase in the area of the finger electrodes 34a. On the other hand, since the back surface field layer 30 has a high criterion in association with recombination, the characteristics of the solar cell 100 do not greatly vary based on the area of the entire back surface field layer 30.

The connecting projections 30c formed at each of the finger electrodes 34a may have a size suitable to enable connection between the finger electrode 34a and the back surface field layer 30. Unnecessarily increasing the size of the connecting projections 30c may increase doping time, surface recombination, and other problems. Thus, the connecting projections 30c preferably have a minimum size to enable connection between the finger electrode 34a and the back surface field layer 30.

In one example, the width W22 of each connecting projection 30c may be equal to or less than the width W21 of the first portion 30a. In one example, the ratio W22/W21 of the width W22 of the connecting projection 30c to the width W21 of the first portion 30a may be within a range of 0.1 to 1.0. When the ratio W22/W21 is below 0.1, the width W22 of the connecting projection 30c is too small to achieve effective connection between the second electrode 34 and the back surface field layer 33. When the ratio W22/S21 exceeds 1.0, the width W22 of the connecting projection 30c is increased, causing deterioration in the characteristics of the solar cell 100. In this case, a lower limit of the ratio W22/W21 is 0.1, which is lower than 0.3. in the case in which the connecting projections 34c are formed at the finger electrode 34a. This is because the area of the entire back surface field layer 30 has less effect on the characteristics of the solar cell 100 than the area of the entire finger electrodes 34a, and therefore the width W21 of the first portion 30a may be greater than the width W11 of each finger electrode 34a of the second electrode 34. Concrete values of the widths W21 and W22 and the ratio thereof may vary according to the size of the solar cell 100, the kind of the solar cell 100, and the like.

The protruding length D2 of the connecting projection 30c may be less than the first pitch P2 between the first portions 30a (generally, equal to the first pitch P1 between the finger electrodes 34a). In this case, the ratio D2/P2 of the protruding length D2 of the connecting projection 30c to the first pitch P2 between the first portions 30a may be 0.6 or less. When the ratio D2/P2 exceeds 0.6, the connecting projections 30c of the neighboring first portions 30a may be connected to each other, and the connecting projections 30c may have an excessively long length, causing deterioration in the characteristics of the solar cell 100. In one example, the ratio D2/P2 of the protruding length D2 of the connecting projection 30c to the first pitch P2 between the first portions 30a may be within a range of 0.1 to 0.6. When the ratio D2/P2 is below 0.1, the protruding length D2 of the connecting projection 30c is too small to sufficiently deal with an alignment error. When the ratio D1/P2 exceeds 0.6, the protruding length D2 of the connecting projection 30c may be unnecessarily increased. In this case, the ratio D2/P2 may have a greater value than that in the case in which the connecting projections 34c are formed at the finger electrode 34a. This is because the area of the entire back surface field layer 30 has less effect on the characteristics of the solar cell 100 than the area of the entire finger electrodes 34a, and therefore the allowable protruding length D2 is relatively long. However, the present invention is not limited thereto, and concrete values of the above dimensions D2 and P2 and the ratio thereof may vary according to the size of the solar cell 100, the kind of the solar cell 100, and the like.

The connecting projections 30c may be spaced apart from one another by a constant second pitch P22. In this case, the second pitch P22 may be greater than the width W21 of the first portion 30a. When the second pitch P22 is less than the width W21 of the first portion 30a, the connecting projections 30c are densely arranged, which may deteriorate characteristics of the solar cell 100.

More specifically, the ratio P22/P2 of the second pitch P22 between the connecting projections 30c to the first pitch P2 between the first portions 30a may be 0.5 or more (for example, within a range of 0.5 to 3.0). In addition, when the ratio is below 0.5, the connecting projections 30c may cause deterioration in the characteristics of the solar cell 100. When the ratio exceeds 3.0, effective connection between the second electrode 34 and the back surface field layer 30 cannot be accomplished under the occurrence of various types of alignment errors.

Here, the second pitch P22 may be within a range of 0.5 mm to 2.0 mm. When the second pitch P22 is below 0.5 mm, the characteristics of the solar cell 100 may be deteriorated. When the second pitch P22 exceeds 2.0 mm, effective connection between the second electrode 34 and the back surface field layer 30 may be impossible under the occurrence of various types of alignment errors. However, the aforementioned numerical values may vary according to the size of the solar cell 100, the kind of the solar cell 100, and the like.

Among the plurality of connecting projections 30c, any one connecting projection 30c proximate to the edge of the solar cell 100 (or the edge of the semiconductor substrate 110) may be spaced apart from the edge of the solar cell 100. Since the back surface field layer 30 may not be formed at the edge of the solar cell 100 by reason of, for example, isolation, eliminating the connecting projection 30c at this portion may minimize the number of the connecting projections 30c. In one example, a distance between the corresponding connecting projection 30c and the edge of the solar cell 100 may be within a range of 0.2 mm to 1.0 mm. However, naturally, the present invention is not limited thereto and various other alternative embodiments are possible.

In addition, among the plurality of connecting projections 30c, any one connecting projection 30c proximate to each bus bar electrode 34b may be spaced apart from the bus bar electrode 34b. This serves to provide the bus bar electrode 34b with a relatively large width so as to compensate for an alignment error near the bus bar electrode 34b. In this way, as a result of the connecting projection 30c and the bus bar electrode 34b being spaced apart from each other, the number of the connecting projections 30c may be minimized. In one example, the distance between the corresponding connecting projection 30c and the bus bar electrode 34b may be within a range of 0.1 mm to 1.0 mm. However, naturally, the present invention is not limited thereto and various other alternative embodiments are possible.

FIG. 9 illustrates that the connecting projections 30a formed at the back surface field layer 30 have a shape and arrangement similar to those of FIG. 2. However, the present example is not limited thereto. Accordingly, naturally, various alternative examples of FIGS. 5 to 8 may be applied to the connecting projections 30a of FIG. 9.

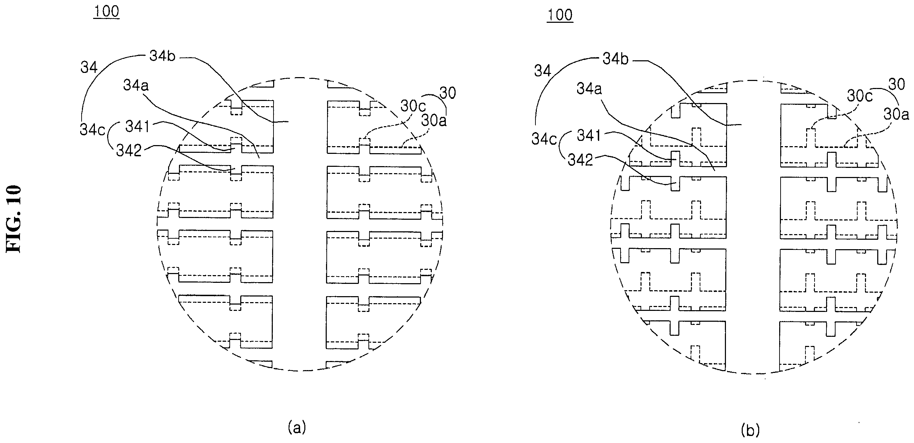

FIG. 10 is a partial rear plan view of a solar cell in accordance with still another example of the solar cell.

Referring to FIG. 10, in the present example, there are first connecting projections 34c formed at the finger electrode 34a and second connecting projections 30c formed at the first portion 30a of the back surface field layer 30. That is, in the present example, the second electrode 34 is provided with the first connecting projections 34c and the back surface field layer 30 is provided with the second connecting projections 30c. With this configuration, electrical connection between the back surface field layer 30 and the second electrode 34 may be accomplished even if a relatively large alignment error occurs between the first portion 30a and the finger electrode 34a.

In FIG. 10, (a) illustrates a case in which no alignment error occurs, and (b) illustrates a case in which the second electrode 34 and the back surface field layer 30 are stably connected to each other via the first and second connecting projections 34c and 30c despite the occurrence of an alignment error. Through provision of both the first and second connecting projections 34c and 30c, as exemplarily shown in (b) of FIG. 10, connection between the second electrode 34 and the back surface field layer 30 may be more stably accomplished.

In this case, dimensions associated with the first connecting projections 34c, such as the width, the protruding length, the first pitch, and the distances from the edge of the solar cell 100 and the bus bar electrode 34b, may correspond respectively to the width W12, the protruding length D1, the second pitch P21, and the distances from the edge of the solar cell 100 and the bus bar electrode 34b with regard to the connecting projections 34c described above with reference to FIG. 2. In addition, dimensions associated with the second connecting projections 30c, such as the width, the protruding length, the second pitch, and the distances from the edge of the solar cell 100 and the bus bar electrode 34b, may correspond respectively to the width W22, the protruding length D2, the second pitch P21, and the distances from the edge of the solar cell 100 and the bus bar electrode 34b with regard to the connecting projections 30c described above with reference to FIG. 9. Accordingly, the above detailed description with reference to FIGS. 2 and 9 may be directly applied to the present example, and thus a further description of the present example will be omitted hereinafter.

As described above, since the area of the entire first portion 30a has less effect on the characteristics of the solar cell 100 than the area of the finger electrode 34a, the width of the first portion 30a may be less than the width of the finger electrode 34a. This configuration may be advantageous to efficiently deal with an alignment error and to maintain excellent characteristics of the solar cell 100.

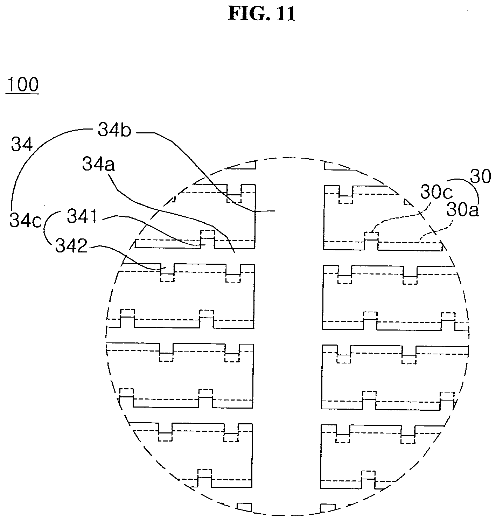

All of the alternative examples of FIGS. 5 to 8 may be applied to the first connecting projection 34c and/or the second connecting projection 30c. In this case, as exemplarily shown in FIG. 10, the first connecting projection 34c and the second connecting projection 30c may have the same or similar configuration. In the embodiment of the solar cell according to the present invention as shown in FIG. 11, the first connecting projection 34c and the second connecting projection 30c have the alternating configurations, and may have different shapes, and the like to deal with various alignment errors. FIG. 11 illustrates that the first connecting projection 34c has the shape and arrangement as shown in FIG. 6 and that the second connecting projection 30c has the shape and arrangement as shown in (e) of FIG. 7. However, naturally, the present invention is not limited thereto, and the first connecting projection 34c and the second connecting projection 30c having various shapes and alternating arrangements may be combined with each other.

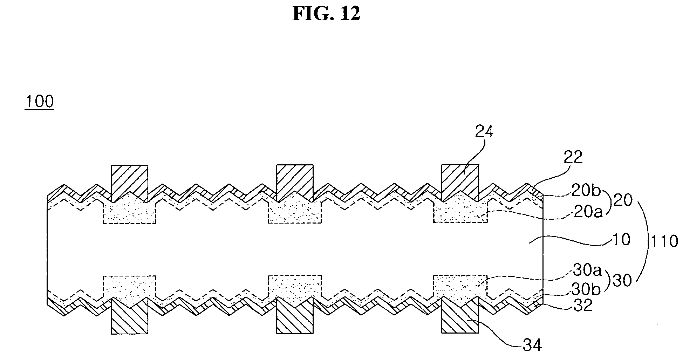

FIG. 12 is a sectional view of a solar cell in accordance with a further embodiment of the present invention.

Referring to FIG. 12, in the solar cell 100 according to the present example, the back surface field layer 30 has a selective configuration including the first portions 30a and a second portion 30b. More specifically, the back surface field layer 30 may include the first portions 30a adjoining to the second electrode 34 (for example, in contact with the second electrode 34) and a second portion 30b where the second electrode 34 is not located. The first portions 30a have a greater dopant density than that of the second portion 30b, and thus have a less resistance than that of the second portion 30b. The second portion 30b has a relatively low dopant density and thus has a relatively high resistance.

Accordingly, in the present embodiment as a result of providing the second portion 30b, corresponding to a region between the neighboring portions of the second electrode 34, with a higher resistance, recombination of electrons and holes may be prevented. This may result in increased current density of the solar cell 100. In addition, as a result of providing the first portions 30a, adjoining to the second electrode 34 (more particularly, adjoining to the plurality of finger electrodes 34a of the second electrode 34), with a lower resistance, the back surface field layer 30 may achieve reduced contact resistance with the second electrode 34. That is, the back surface field layer 30 of the present example may maximize the efficiency of the solar cell 100 owing to a selective configuration thereof.

In addition, the emitter layer 20 may include a first portion 20a adjoining to the first electrode 34, and a second portion 20b where at least the first electrode 24 is not located. The first portion 20a has a greater dopant density than that of the second portion 20b, and thus has a less resistance than that of the second portion 20b. The second portion 20b has a relatively low dopant density and thus has a relatively high resistance.

In this way, the present example may realize a shallow emitter by providing a light receiving region between the neighboring portions of the first electrode 24 with the second portion 20b having a relatively high resistance. In this way, current density of the solar cell 100 may be increased. In addition, the emitter layer 20 may achieve reduced contact resistance with the first electrode 24 as a result of providing the first portion 20a, adjoining to the first electrode 24, with a relatively low resistance. That is, the emitter layer 20 of the present example in the form of a selective emitter may maximize the efficiency of the solar cell 100.

Although the present example describes that both the emitter layer 20 and the back surface field layer 30 have a selective configuration, the present example is not limited thereto. Any one of the emitter layer 20 and the back surface field layer 30 may have a selective configuration.

As is apparent from the above description, in a solar cell according to the embodiment of the present invention, connecting projections are formed at any one of a second electrode and a back surface field layer, which may ensure effective connection between the second electrode and the back surface field layer, resulting in a reduced defect rate of the solar cell. As a result, the solar cell may achieve enhanced reliability and considerably enhanced productivity. In this case, according to the embodiment, with regard to the connecting projection, for example, a width, a protruding length, a pitch, and distances from the edge of the solar cell and a bus bar electrode are defined to maintain the area of the second electrode at a small value and to achieve more effective connection between the second electrode and the back surface field layer. In this way, the solar cell may maintain a high level of characteristics and a considerably reduced defect rate.

The above described features, configurations, effects, and the like are included in the embodiment of the present invention, and should not be limited to only the embodiment. In addition, the features, configurations, effects, and the like as illustrated in the embodiment may be implemented with regard to other examples as they are combined with one another or modified by those skilled in the art. Thus, content related to these combinations and modifications should be construed as including in the scope of the invention as disclosed in the accompanying claims.

## Claims

1. A solar cell (100) comprising:
a semiconductor substrate (110);
an emitter layer (20) formed at a front surface of the semiconductor substrate (110), the emitter layer being of a conductive type different from that of the semiconductor substrate (100);
a first electrode (24) having a plurality of first fingers (24a), electrically connected to the emitter layer (20);
a back surface field layer (30) having a plurality of first portions (30a) locally formed at a back surface of the semiconductor substrate (110) at a first pitch (P1, P2) along a direction perpendicular to the longitudinal direction of the first portions (30a), the back surface field layer (30) being of the same conductive type as that of the semiconductor substrate (110); and
a second electrode (34) having a plurality of second fingers (34a) arranged at a first pitch (P1, P2)and electrically connected to the plurality of first portions (30a) of the back surface field layer (30),
wherein the plurality of first portions (30a) of the back surface field layer (30) and the plurality of second fingers (34a) extend in a same direction,
wherein the plurality of first portions (30a) of the back surface field layer (30) and the plurality of second fingers (34a) have connecting projections (30c, 34c) protruding from the first portions (30a) and the second fingers (34a), the connecting projections (30c, 34c) extending parallel to the back surface in a direction perpendicular to the direction in which the first portions (30a) and the second fingers (34a) extend, and the connecting projections (30c, 34c) being spaced apart from one another by a second pitch (P22),
wherein each connecting projection (30c, 34c) includes a first protruding portion (341) formed at one side of the first portions (30a) and the second fingers (34a), and a second protruding portion (342) formed at the opposite side of the first portions (30a) and the second fingers (34a), and
wherein the first protruding portion (341) and the second protruding portion (342) are alternately arranged on the first portions (30a) and the second fingers (34a).

2. The solar cell (100) according to claim 1, wherein a width of the connecting projection (30c, 34c) is less than or equal to a width of any one of the finger electrode (34a) and the first portion (30a), wherein the width of the connecting projection (30c, 34c) extends in the longitudinal direction of the finger electrode (34a) and the first portion (30a).

3. The solar cell (100) according to claim 2, wherein at least one of the following is fulfilled for the connecting projection (30c, 34c):
wherein the connecting projection (30c, 34c) is formed at the finger electrode (34a), and wherein a ratio of the width of the connecting projection (30c, 34c) to the width of the finger electrode (34a) is within a range of 0.3 to 1.0; or
wherein the connecting projection (30c, 34c) is formed at the first portion (30a), and wherein a ratio of the width of the connecting projection (30c, 34c) to the width of the first portion (30a) is within a range of 0.1 to 1.0

4. The solar cell (100) according to claim 1, wherein a protruding length of the connecting projection (30c, 34c) is less than the first pitch (P1), wherein the length of the connecting projection (30c, 34c) extends in a direction perpendicular to the finger electrode (34a) and the first portion (30a).

5. The solar cell (100) according to claim 4, wherein a ratio of the protruding length of the connecting projection (30c, 34c) to the first pitch (P1) is 0.6 or less.

6. The solar cell (100) according to claim 5, wherein at least one of the following is fulfilled for the connecting projection (30c, 34c):
wherein the connecting projection (30c, 34c) is formed at the finger electrode (34a), and a ratio of the protruding length of the connecting projection (30c, 34c) to the first pitch (P1) is within a range of 0.05 to 0.3; or,
wherein the connecting projection (30c, 34c) is formed at the first portion (30a), and a ratio of the protruding length of the connecting projection (30c, 34c) to the first pitch (P1) is within a range of 0.1 to 0.6.

7. The solar cell (100) according to claim 1, wherein the at least one connecting projection (30c, 34c) includes a plurality of connecting projections (30c, 34c) spaced apart from one another by a second pitch (P22), and wherein the second pitch (P22) is greater than a width of any one of the finger electrode (34a) and the first portion (30a), wherein the width of the finger electrode (34a) and the first portion (30a) extends along a direction perpendicular to the longitudinal directions of the finger electrode and first portions.

8. The solar cell (100) according to claim 7, wherein at least one of the following is fulfilled for the second pitch (P22):
wherein the second pitch (P22) is within a range of 0.5 mm to 2.0 mm; and
wherein a ratio of the second pitch (P22) to the first pitch (P1) is within a range of 0.5 to 3.

9. The solar cell (100) according to claim 1, wherein the second electrode (34) further includes at least one bus bar electrode (34b) configured to connect the finger electrodes (34a) to one another,
wherein the at least one connecting projection (30c, 34c) includes a plurality of connecting projections (30c, 34c), and
wherein, among the connecting projections (30c, 34c), any one connecting projection (30c, 34c) proximate to the bus bar electrode (34b) is spaced apart from the bus bar electrode (34b).

10. The solar cell (100) according to claim 1, wherein the at least one connecting projection (30c, 34c) includes a plurality of connecting projections (30c, 34c), and
wherein, among the connecting projections (30c, 34c), any one connecting projection (30c, 34c) proximate to the edge of the semiconductor substrate (110) is spaced apart from the edge of the semiconductor substrate (110).

11. The solar cell (100) according to claim 1, wherein the connecting projection (43c) is orthogonal to any one of the finger electrode (34a) and the first portion

## Patentansprüche

1. Solarzelle (100), umfassend:
ein Halbleitersubstrat (110);
eine Emitterschicht (20), die an einer Vorderseite des Halbleitersubstrats (110) gebildet ist, wobei die Emitterschicht von einem leitfähigen Typ ist, die sich von dem des Halbleitersubstrats (100) unterscheidet;
eine erste Elektrode (24), die eine Mehrzahl von ersten Fingern (24a) aufweist und die mit der Emitterschicht (20) elektrisch verbunden ist;
eine Rückseiten-Feldebene (30), die eine Mehrzahl von ersten Abschnitten (30a) aufweist, die lokal an einer Rückseite des Halbleitersubstrats (110) in einem ersten Abstand (P1, P2) entlang einer Richtung senkrecht zur Längsrichtung der ersten Abschnitte (30a) gebildet sind, wobei die Rückseiten-Feldebene (30) von demselben leitfähigen Typ ist wie der des Halbleitersubstrats (110); und
eine zweite Elektrode (34), die eine Mehrzahl von zweiten Fingern (34a) aufweist, die in einem ersten Abstand (P1, P2) angeordnet sind und die mit der Mehrzahl von ersten Abschnitten (30a) der Rückseiten-Feldschicht (30) elektrisch verbunden sind,
wobei sich die Mehrzahl von ersten Abschnitten (30a) der Rückseiten-Feldebene (30) und die Mehrzahl von zweiten Fingern (34a) in eine selbe Richtung erstrecken,
wobei die Mehrzahl von ersten Abschnitten (30a) der Rückseiten-Feldebene (30) und die Mehrzahl von zweiten Fingern (34a) Verbindungsvorsprünge (30c, 34c) aufweisen, die von den ersten Abschnitten (30a) und den zweiten Fingern (34a) vorspringen, wobei sich die Verbindungsvorsprünge (30c, 34c) parallel zur Rückseite in eine Richtung senkrecht zur Richtung erstrecken, in welche sich die ersten Abschnitte (30a) und die zweiten Finger (34a) erstrecken, und wobei die Verbindungsvorsprünge (30c, 34c) voneinander über einen zweiten Abstand (P22) beabstandet sind,
wobei jeder Verbindungsvorsprung (30c, 34c) einen ersten vorspringenden Abschnitt (341), der auf einer Seite der ersten Abschnitte (30a) und der zweiten Finger (34a) gebildet ist, und einen zweiten vorspringenden Abschnitt (342) umfasst, der auf der gegenüberliegenden Seite der ersten Abschnitte (30a) und der zweiten Finger (34a) gebildet ist, und
wobei der erste vorspringende Abschnitt (341) und der zweite vorspringende Abschnitt (342) abwechselnd an den ersten Abschnitten (30a) und den zweiten Fingern (34a) angeordnet sind.

2. Solarzelle (100) nach Anspruch 1, wobei eine Breite des Verbindungsvorsprungs (30c, 34c) geringer als oder gleich einer Breite von entweder der Fingerelektrode (34a) oder dem ersten Abschnitt (30a) ist, wobei sich die Breite des Verbindungsvorsprungs (30c, 34c) in Längsrichtung der Fingerelektrode (34a) und des ersten Abschnitts (30a) erstreckt.

3. Solarzelle (100) nach Anspruch 2, wobei wenigstens eines des Folgenden für den Verbindungsvorsprung (30c, 34c) erfüllt ist:
wobei der Verbindungsvorsprung (30c, 34c) an der Fingerelektrode (34a) gebildet ist, und wobei ein Verhältnis der Breite des Verbindungsvorsprungs (30c, 34c) zur Breite der Fingerelektrode (34a) innerhalb einer Spanne von 0,3 bis 1,0 liegt; oder
wobei der Verbindungsvorsprung (30c, 34c) an dem ersten Abschnitt (30a) gebildet ist, und wobei ein Verhältnis der Breite des Verbindungsvorsprungs (30c, 34c) zur Breite des ersten Abschnitts (30a) innerhalb einer Spanne von 0,1 bis 1,0 liegt.

4. Solarzelle (100) nach Anspruch 1, wobei eine vorspringende Länge des Verbindungsvorsprungs (30c, 34c) geringer als der erste Abstand (P1) ist, wobei sich die Länge des Verbindungsvorsprungs (30c, 34c) in eine Richtung senkrecht zur Fingerelektrode (34a) und zum ersten Abschnitt (30a) erstreckt.

5. Solarzelle (100) nach Anspruch 4, wobei ein Verhältnis der vorspringenden Länge des Verbindungsvorsprungs (30c, 34c) zum ersten Abstand (P1) 0,6 oder weniger ist.

6. Solarzelle (100) nach Anspruch 5, wobei wenigstens eines des Folgenden für den Verbindungsvorsprung (30c, 34c) erfüllt ist:
wobei der Verbindungsvorsprung (30c, 34c) an der Fingerelektrode (34a) gebildet ist, und wobei ein Verhältnis der vorspringenden Länge des Verbindungsvorsprungs (30c, 34c) zum ersten Abstand (P1) innerhalb einer Spanne von 0,05 bis 0,3 liegt; oder
wobei der Verbindungsvorsprung (30c, 34c) an dem ersten Abschnitt (30a) gebildet ist, und wobei ein Verhältnis der vorspringenden Länge des Verbindungsvorsprungs (30c, 34c) zum ersten Abstand (P1) innerhalb einer Spanne von 0,1 bis 0,6 liegt.

7. Solarzelle (100) nach Anspruch 1, wobei der wenigstens eine Verbindungsvorsprung (30c, 34c) eine Mehrzahl von Verbindungsvorsprüngen (30c, 34c) umfasst, die voneinander über einen zweiten Abstand (P22) beabstandet sind, und
wobei der zweite Abstand (P22) größer als eine Breite entweder der Fingerelektrode (34a) oder des ersten Abschnitts (30a) ist, wobei sich die Breite der Fingerelektrode (34a) und des ersten Abschnitts (30a) entlang einer Richtung senkrecht zu den Längsrichtungen der Fingerelektrode und der ersten Abschnitte erstreckt.

8. Solarzelle (100) nach Anspruch 7, wobei wenigstens eines des Folgenden für den zweiten Abstand (P22) erfüllt ist:
wobei der zweite Abstand (P22) innerhalb einer Spanne von 0,5 mm bis 2,0 mm liegt; und
wobei ein Verhältnis des zweiten Abstands (P22) zum ersten Abstand (P1) innerhalb einer Spanne von 0,5 bis 3 liegt.

9. Solarzelle (100) nach Anspruch 1, wobei die zweite Elektrode (34) ferner wenigstens eine Sammelschienenelektrode (34b) umfasst, die dazu ausgestaltet ist, die Fingerelektroden (34a) miteinander zu verbinden,
wobei der wenigstens eine Verbindungsvorsprung (30c, 34c) eine Mehrzahl von Verbindungsvorsprüngen (30c, 34c) umfasst, und
wobei, unter den Verbindungsvorsprüngen (30c, 34c), jeder Verbindungsvorsprung (30c, 34c) in der Nähe der Sammelschienenelektrode (34b) von der Sammelschienenelektrode (34b) beabstandet ist.

10. Solarzelle (100) nach Anspruch 1, wobei der wenigstens eine Verbindungsvorsprung (30c, 34c) eine Mehrzahl von Verbindungsvorsprüngen (30c, 34c) umfasst, und
wobei, unter den Verbindungsvorsprüngen (30c, 34c), jeder Verbindungsvorsprung (30c, 34c) in der Nähe der Kante des Halbleitersubstrats (110) von der Kante des Halbleitersubstrats (110) beabstandet ist.

11. Solarzelle (100) nach Anspruch 1, wobei der Verbindungsvorsprung (43c) orthogonal zu entweder der Fingerelektrode (34a) oder dem ersten Abschnitt ist.

## Revendications

1. Cellule solaire (100) comprenant :
un substrat semi-conducteur (110) ;
une couche d'émetteur (20) formée à une surface avant du substrat semi-conducteur (110), la couche d'émetteur étant d'un type de conductivité différent de celui du substrat semi-conducteur (110) ;
une première électrode (24) ayant une pluralité de premiers doigts (24a), reliés électriquement à la couche d'émetteur (20) ;
une couche de champ de surface arrière (30) ayant une pluralité de premières parties (30a) formées localement à une surface arrière du substrat semi-conducteur (110) à un premier pas (P1, P2) le long d'une direction perpendiculaire à la direction longitudinale des premières parties (30a), la couche de champ de surface arrière (30) étant du même type de conductivité que celui du substrat semi-conducteur (110) ; et
une seconde électrode (34) ayant une pluralité de seconds doigts (34a) disposés à un premier pas (P1, P2) et reliés électriquement à la pluralité de premières parties (30a) de la couche de champ de surface arrière (30),
la pluralité de premières parties (30a) de la couche de champ de surface arrière (30) et la pluralité de seconds doigts (34a) s'étendant dans une même direction,
la pluralité de premières parties (30a) de la couche de champ de surface arrière (30) et la pluralité de seconds doigts (34a) ayant des saillies de liaison (30c, 34c) faisant saillie à partir des premières parties (30a) et des seconds doigts (34a), les saillies de liaison (30c, 34c) s'étendant parallèlement à la surface arrière dans une direction perpendiculaire à la direction dans laquelle les premières parties (30a) et les seconds doigts (34a) s'étendent, et les saillies de liaison (30c, 34c) étant espacées les unes des autres d'un second pas (P22),
chaque saillie de liaison (30c, 34c) comprenant une première partie de saillie (341) formée à un côté des premières parties (30a) et des seconds doigts (34a), et une seconde partie de saillie (342) formée au côté opposé des premières parties (30a) et des seconds doigts (34a), et
la première partie de saillie (341) et la seconde partie de saillie (342) étant disposées de manière alternée sur les premières parties (30a) et les seconds doigts (34a).

2. Cellule solaire (100) selon la revendication 1, dans laquelle une largeur de la saillie de liaison (30c, 34c) est inférieure ou égale à une largeur de l'une quelconque parmi l'électrode à doigts (34a) et la première partie (30a), la largeur de la saillie de liaison (30c, 34c) s'étendant dans la direction longitudinale de l'électrode à doigts (34a) et de la première partie (30a).

3. Cellule solaire (100) selon la revendication 2, dans laquelle au moins l'un de ce qui est satisfait pour la saillie de liaison (30c, 34c) :
la saillie de liaison (30c, 34c) est formée à l'électrode à doigts (34a), et un rapport de la largeur de la saillie de liaison (30c, 34c) à la largeur de l'électrode à doigts (34a) se situe dans une plage allant de 0,3 à 1,0 ; ou
la saillie de liaison (30c, 34c) est formée à la première partie (30a), et un rapport de la largeur de la saillie de liaison (30c, 34c) à la largeur de la première partie (30a) se situe dans une plage allant de 0,1 à 1,0.

4. Cellule solaire (100) selon la revendication 1, dans laquelle une longueur de saillie de la saillie de liaison (30c, 34c) est inférieure au premier pas (P1), la longueur de la saillie de liaison (30c, 34c) s'étendant dans une direction perpendiculaire à l'électrode à doigts (34a) et la première partie (30a).

5. Cellule solaire (100) selon la revendication 4, dans laquelle un rapport de la longueur de saillie de la saillie de liaison (30c, 34c) au premier pas (P1) est 0,6 ou moins.

6. Cellule solaire (100) selon la revendication 5, dans laquelle au moins l'un de ce qui suit est satisfait pour la saillie de liaison (30c, 34c) :
la saillie de liaison (30c, 34c) est formée à l'électrode à doigts (34a), et un rapport de la longueur de saillie de la saillie de liaison (30c, 34c) au premier pas (P1) se situe dans une plage allant de 0,05 à 0,3 ; ou
la saillie de liaison (30c, 34c) est formée à la première partie (30a), et un rapport de la longueur de saillie de la saillie de liaison (30c, 34c) au premier pas (P1) se situe dans une plage allant de 0,1 à 0,6.

7. Cellule solaire (100) selon la revendication 1, dans laquelle l'au moins une saillie de liaison (30c, 34c) comprend une pluralité de saillies de liaison (30c, 34c) espacées les unes des autres d'un second pas (P22), et le second pas (P22) étant plus grand qu'une largeur de l'une quelconque parmi l'électrode à doigts (34a) et la première partie (30a), la largeur de l'électrode à doigts (34a) et de la première partie (30a) s'étendant le long d'une direction perpendiculaire aux directions longitudinales de l'électrode à doigts et des premières parties.

8. Cellule solaire (100) selon la revendication 7, dans laquelle au moins l'un de ce qui suit est satisfait pour le second pas (P22) :
le second pas (P22) se situe dans une plage allant de 0,5 mm à 2,0 mm ; et
un rapport du second pas (P22) au premier pas (P1) se situe dans une plage allant de 0,5 à 3.

9. Cellule solaire (100) selon la revendication 1, dans laquelle la seconde électrode (34) comprend en outre au moins une électrode à barre omnibus (34b) configurée pour relier les électrodes à doigts (34a) les unes aux autres,
l'au moins une saillie de liaison (30c, 34c) comprenant une pluralité de saillies de liaison (30c, 34c), et
parmi les saillies de liaison (30c, 34c), toute saillie de liaison (30c, 34c) à proximité de l'électrode à barre omnibus (34b) étant espacée de l'électrode à barre omnibus (34b).

10. Cellule solaire (100) selon la revendication 1, dans laquelle l'au moins une saillie de liaison (30c, 34c) comprend une pluralité de saillies de liaison (30c, 34c), et
parmi les saillies de liaison (30c, 34c), toute saillie de liaison (30c, 34c) à proximité du bord du substrat semi-conducteur (110) étant espacée du bord du substrat semi-conducteur (110).

11. Cellule solaire (100) selon la revendication 1, dans laquelle la saillie de liaison (43c) est orthogonale à l'une quelconque parmi l'électrode à doigts (34a) et la première partie.
